# FASCICULE DE BREVET EUROPEEN

(11) **EP 3 776 665 B1**
(45) Date de publication et mention de la délivrance du brevet: **26.01.2022**
(21) Numéro de dépôt: 19724902.2
(22) Date de dépôt: 10.04.2019
(51) Int. Cl.: H01L 31/0224, H01L 31/074, H01L 31/0468

(54) **OPTIMISATION DU CONTACT ÉLECTRIQUE MÉTAL/MÉTAL DANS UN DISPOSITIF PHOTOVOLTAÏQUE SEMI-TRANSPARENT EN COUCHES MINCES**
OPTIMIERUNG DES ELEKTRISCHEN METALL/METALL-KONTAKTS IN EINER SEMITRANSPARENTEN FOTOVOLTAISCHEN DÜNNSCHICHTVORRICHTUNG
OPTIMIZATION OF THE METAL/METAL ELECTRICAL CONTACT IN A THIN-FILM SEMITRANSPARENT PHOTOVOLTAIC DEVICE

(30) Priorité: 11.04.2018 FR 1800301
(43) Date de publication de la demande: 17.02.2021
(73) Titulaire: Garmin Switzerland GmbH, 8200 Schaffhausen (CH)
(72) Inventeur: BOUCHOUCHA, Mohamed, 13170 Les Pennes Mirabeau (FR)
(74) Mandataire: Bird & Bird LLP
(86) Numéro de dépôt international: PCT/IB2019/000296
(87) Numéro de publication internationale: WO 2019/197893

(56) Documents cités:
- FR-A1- 2 673 329
- FR-A1- 2 820 241
- FR-A1- 3 017 997

## Description

L'invention concerne un dispositif photovoltaïque semi-transparent en couches minces, pourvu d'un contact électrique métal/métal optimisé pour réduire sa résistance électrique.

### ETAT DE LA TECHNIQUE

On distingue dans la littérature plusieurs types de matériaux semi-conducteurs employés dans les dispositifs photovoltaïques, tels que les matériaux solides cristallisés, les matériaux organiques (polymères ou petites molécules) ou encore les couches minces inorganiques (amorphes ou poly cristallines). Dans la plupart des cas, une couche métallique est employée pour collecter les charges électriques générées par ces dispositifs sous illumination. Ces couches métalliques forment généralement une électrode, des bus de collecte ou les interconnexions entre les différentes cellules composant le module photovoltaïque. Dans la suite du document, on ne considère que les dispositifs photovoltaïques possédant des couches métalliques.

Afin d'améliorer les performances des modules photovoltaïques, il est connu de l'homme du métier qu'augmenter par exemple l'épaisseur des électrodes métalliques permet de diminuer les pertes par effet Joule. Dans ce cas, il faut donc mettre en contact un métal A ayant été à l'air libre (l'électrode métallique de la cellule initiale) avec un autre conducteur B pour épaissir ladite électrode, et donc augmenter sa conductivité globale. Cependant, certains métaux, dont l'aluminium (Al) et le cuivre (Cu), couramment utilisés pour former par exemple l'électrode métallique des dispositifs photovoltaïques en couches minces, s'oxydent en surface à l'air libre, voire même sous des atmosphères dont les taux d'oxygène sont contrôlés. Il y a formation d'un oxyde appelé couramment oxyde natif. Cette fine couche d'oxyde natif de quelques nanomètres d'épaisseur est le plus souvent isolante électriquement. C'est le cas notamment des oxydes d'aluminium et de cuivre. Dans ce cas, l'empilement constitué de l'électrode métallique A, de son oxyde et du conducteur B ne présente pas une conductivité améliorée telle qu'espérée par l'épaississement à posteriori de l'électrode métallique car la résistance électrique de contact entre les deux métaux est très importante, due à la présence entre les deux métaux de l'oxyde natif.

Le même phénomène est observé lorsque l'on cherche à mettre en série ou en parallèle à posteriori plusieurs cellules photovoltaïques afin de contrôler les niveaux de tension et de courant en sortie des modules photovoltaïques. De même que précédemment, il est nécessaire d'optimiser la conductivité de l'empilement métal A/oxyde natif/métal B afin de maximiser les performances desdits modules.

Cette même problématique apparaît aussi dans les dispositifs photovoltaïques semi-transparents en couches minces. Ces dispositifs photovoltaïques sont composés :
- De surfaces pleines et opaques contenant l'empilement des couches photovoltaïques actives,
- De surfaces transparentes formées du substrat transparent et éventuellement de matériaux transparents conducteurs ou isolants.

La semi-transparence peut par exemple être réalisée à partir de modules photovoltaïques pleins, c'est-à-dire ne présentant pas de zones de transparence. Dans ce cas, les zones transparentes sont généralement obtenues par des procédés de gravure photo lithographique en gravant les couches de l'empilement photovoltaïque pour dégager des zones de transparence à la lumière. Par exemple dans le cas de modules photovoltaïques à base de silicium amorphe, l'empilement est composé de la manière suivante :
- un substrat, par exemple du verre ;
- une première électrode transparente, par exemple un oxyde de zinc dopé à l'aluminium ;
- une couche active photovoltaïque, par exemple une jonction à base de silicium amorphe ;
- une seconde électrode métallique, par exemple de l'aluminium.

Après la gravure des différentes couches constituant l'empilement photovoltaïque (la première électrode, la couche active photovoltaïque et la seconde électrode), des reprises de contact de type métal/métal sont nécessaires afin de connecter les zones électriquement actives aux bus de collecte et de connecter les cellules unitaires entre elles (en série et/ou parallèle) afin d'obtenir un module photovoltaïque. La problématique de reprise de contact métal/métal est renforcée dans le cas des dispositifs photovoltaïques semi-transparents, car les reprises de contact sont réalisées sur des surfaces dont les côtés les plus larges n'excèdent pas quelques dizaines de micromètres générant des surfaces de reprises de contact de quelques centaines de micromètres carrés. Or si l'électrode métallique, comme mentionné dans l'exemple ci ci-dessus, est de l'aluminium, l'oxyde natif, ici de l'alumine, peut avoir une épaisseur de 3 à 6 nm. La combinaison de ce matériau avec une surface de contact d'à peine quelques centaines de micromètres carrés donne un contact électrique précaire présentant une forte résistance électrique et qui se traduit par une dégradation de l'efficacité électrique du dispositif.

Une des solutions pour pallier cette problématique serait de modifier la nature de l'électrode métallique. Cette solution n'est pas intéressante d'un point de vue industriel car l'aluminium est un matériau privilégié dans le cadre de modules photovoltaïques à base de silicium amorphe pour les raisons suivantes :
- faible coût ;
- faible résistivité ;
- compatibilité avec le matériau de la couche active photovoltaïque dans le cas notamment du silicium amorphe ;
- facilité d'enchainement des étapes de gravure pour générer la semi-transparence ;
- disponibilité et maîtrise par les industriels des procédés de dépôt et de gravure.

Une autre solution consiste à supprimer la couche d'alumine qui s'est formée à sa surface avant dépôt du second métal permettant la reprise de contact. Il est possible d'utiliser par exemple une gravure plasma, et de déposer le second métal immédiatement après la gravure plasma, sans avoir cassé les conditions de vide entre l'étape de gravure et celle du dépôt métallique. Cette étape nécessite un équipement de dépôt ayant un module plasma dans la chambre de dépôt ou dans une chambre annexe. Cette configuration peut ne pas être disponible dans les équipements de production et dans ce cas l'investissement pour les mettre à niveau peut être conséquent.

Le document FR 3 017 997 A1 décrit un dispositif photovoltaïque semi-transparent à couches minces comportant un substrat transparent, une électrode avant disposée sur le substrat transparent et constituée d'un matériau électriquement conducteur et transparent, un absorbeur, une électrode arrière constituée d'une couche conductrice métallique en contact avec l'absorbeur, une couche métallique de reprise de contact et une zone de reprise de contact de type électrode arrière/couche métallique de reprise de contact.

### BUT DE L'INVENTION

L'invention a pour but de proposer un dispositif photovoltaïque semi-transparent en couches minces dont les reprises de contact métal/métal sont optimisées afin de minimiser les résistances électriques de contact métal/métal et d'augmenter ainsi les performances électriques dudit dispositif photovoltaïque.

Plus précisément, l'invention vise à :
- minimiser voire à supprimer la formation de l'oxyde natif d'aluminium en ajoutant une couche barrière après le dépôt de l'aluminium :
- permettre l'obtention de la semi-transparence par des étapes de gravures compatibles avec les contraintes industrielles ;
- minimiser la résistivité au niveau des reprises de contacts et ce même lorsque les surfaces de reprise de contact sont de très petites dimensions, de l'ordre de la centaine de micromètres carrés.

### OBJETS DE L'INVENTION

Dans la suite du document, un dispositif photovoltaïque désigne tout type de cellule ou module photovoltaïque. Les modules photovoltaïques sont composés d'une pluralité de cellules photovoltaïques connectées entre elles selon une architecture série, parallèle, série-parallèle ou parallèle-série. Un dispositif photovoltaïque en couches minces fait référence à des dispositifs photovoltaïques constitués d'un empilement de couches minces d'épaisseur inférieure à 20 µm (hors substrat). Un dispositif photovoltaïque semi-transparent est composé de zones de transparence et de zones actives photovoltaïques opaques.

Dans son principe de base, l'invention a pour objet un dispositif photovoltaïque semi-transparent à couches minces comportant au moins :
- un substrat transparent, par exemple du verre ou un polymère (d'épaisseur comprise entre quelques centaines de µm à quelques mm) ;
- une électrode avant constituée d'un matériau électriquement conducteur et transparent, par exemple un oxyde transparent conducteur tel que le ZnO:Al (oxyde de zinc dopé à l'aluminium), et disposée sur le substrat transparent ;
- une ou plusieurs couche(s) photo-active(s) appelée(s) absorbeur, par exemple à base de silicium amorphe, de couches organiques, de pérovskite ;
- une électrode arrière constituée d'un empilement d'au moins :
   ∘ une couche conductrice métallique d'épaisseur E2 en contact avec ledit absorbeur, par exemple de l'aluminium, de l'argent, du cuivre ;
   ∘ une couche barrière métallique d'épaisseur E1, par exemple du molybdène, du nickel, déposée de manière homogène sur l'ensemble de ladite couche conductrice métallique ;
- une couche métallique de reprise de contact, par exemple de l'aluminium, de l'argent, du cuivre ;
- une zone de reprise de contact de type électrode arrière / couche métallique de reprise de contact.

Selon l'invention, l'épaisseur E1 de ladite couche barrière métallique est supérieure à 5% de l'épaisseur E2 de ladite couche conductrice métallique et est supérieure à 5 nm.

Au sein des dispositifs photovoltaïques semi-transparents à couches minces, les reprises de contact de type métal/métal entre l'électrode arrière et une couche métallique de reprise de contact sont nécessaires. Elles permettent de connecter électriquement les zones actives photovoltaïques entre elles, et les zones actives photovoltaïques aux bus de collecte.

Selon l'architecture choisie pour obtenir la semi-transparence des dispositifs photovoltaïques, les surfaces de reprises de contact peuvent être de l'ordre de quelques centaines de micromètres carrés. En ce cas, elles nécessitent une optimisation de la résistance électrique de contact. Selon l'invention, cette optimisation est réalisée grâce aux caractéristiques de l'électrode arrière constituée d'un empilement d'au moins :
∘ une couche conductrice métallique en contact avec l'absorbeur, par exemple de l'aluminium, de l'argent, du cuivre ;
∘ une couche barrière métallique en contact avec ladite couche conductrice métallique, par exemple du molybdène ou du nickel ;

La couche conductrice métallique associée à la couche métallique de reprise de contact permet de collecter l'électricité produite par l'absorbeur et d'assurer sa conduction jusqu'aux points de sortie du modules (généralement un plot de polarité positive et un plot de polarité négative).

La couche barrière métallique permet de supprimer l'apparition d'un oxyde natif de ladite couche conductrice métallique, oxyde pouvant être à l'origine, notamment dans le cas de faibles surfaces de reprise de contact, d'une augmentation de la résistivité de la reprise de contact, et donc d'une diminution des performances électriques du dispositif photovoltaïque.

Cependant, le choix de la couche conductrice métallique et de la couche barrière métallique est conditionnée entre autres par :
- les caractéristiques physiques des matériaux (conductivité, diffusion dans l'absorbeur, ...) ;
- les procédés de gravure permettant la réalisation de la semi-transparence au sein des empilements photovoltaïques, et notamment selon la gravure des couches constituant l'électrode arrière ;
- les coûts de production.

Les dispositifs photovoltaïques semi-transparents à couches minces selon l'invention sont caractérisés en ce que l'épaisseur E1 de ladite couche barrière métallique est supérieure à 5% de l'épaisseur E2 de ladite couche conductrice métallique et est supérieure à 5 nm afin que la couche barrière métallique assure sa fonction de barrière à l'oxydation et ne soit pas sur-gravée lors de la réalisation de la semi-transparence.

Avantageusement, l'épaisseur de la couche barrière métallique est inférieure à 100 nm afin de ne pas augmenter la résistivité de l'ensemble des pistes conductrices constituées de l'empilement électrode arrière / couche métallique de reprise de contact.

Selon un mode de réalisation avantageux, la couche barrière métallique est une couche de molybdène, de nickel, d'argent, de palladium, de platine, d'or, de chrome ou de tungstène.

Selon un mode de réalisation avantageux, l'absorbeur est une jonction à base de silicium amorphe.

Selon un mode de réalisation, la couche conductrice métallique est une couche d'aluminium, de cuivre, d'argent ou un alliage Aluminium/Cuivre.

Avantageusement, pour les dispositifs photovoltaïques semi-transparents à couches minces à base de silicium amorphe, la couche conductrice métallique est une couche d'aluminium d'épaisseur E2 comprise entre 50 nm et 2000 nm et la couche barrière métallique est une couche de molybdène ou de nickel. Par exemple, une couche conductrice d'aluminium de 500 nm d'épaisseur sera avantageusement associée à une couche barrière de molybdène d'une épaisseur de 50 nm.

Selon un mode de réalisation du dispositif selon l'invention, la zone de reprise de contact métal/métal présente une surface de l'ordre de la centaine de micromètres carrés.

### DESCRIPTION DETAILLEE

L'invention est maintenant décrite plus en détail à l'aide de la description des figures 1 à 2.
La figure 1A est une vue en coupe d'un empilement photovoltaïque.
La figure 1B est une vue de dessus de l'empilement photovoltaïque de la figure 1A au sein duquel a été réalisée la transparence.
La figure 1C est une vue de dessus similaire à la figure 1B à laquelle ont été ajoutées les zones de reprise de contact de type VIA.
La figure 1D est une vue en coupe selon la direction X de la figure 1C.
La figure 1E est une vue en coupe issue de la figure 1D à laquelle a été ajoutée la couche d'isolation.
La figure 1F est une vue en coupe issue de la figure 1E à laquelle a été ajoutée la couche métallique de reprise de contact.
La figure 2 est une vue en coupe d'une zone de reprise de contact optimisée selon l'invention.

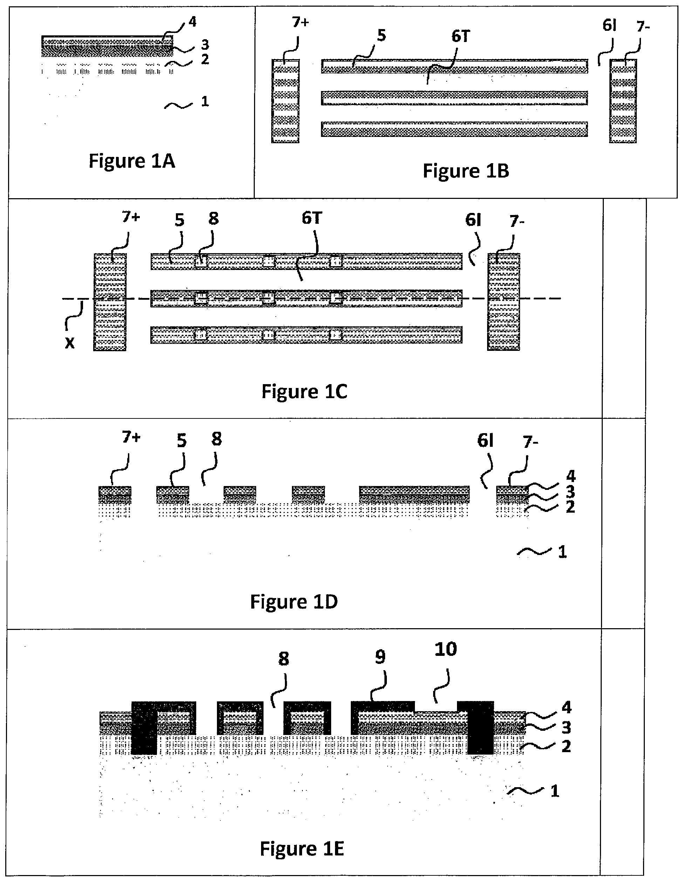

La figure 1A est une vue en coupe d'un empilement photovoltaïque. Dans cet exemple, l'empilement est constitué :
- d'un substrat en verre (1) ;
- d'une électrode avant (2), à savoir un oxyde conducteur transparent, par exemple de l'oxyde de zinc (ZnO) ;
- d'une couche d'absorbeur (3) à base de silicium amorphe (a_Si)
- d'une électrode arrière (4) en métal.

Il est possible de transformer, par des procédés de gravure photo lithographique connus de l'homme du métier, cet empilement pour obtenir une cellule photovoltaïque semi-transparente. La première étape de ce procédé consiste à réaliser les zones de transparence (6T) au sein des zones actives et à isoler les bus de collecte (7) par des zones de transparence (6I). Les zones de transparence (6T et 6I) sont réalisées par gravures successives de l'électrode arrière (4), de l'absorbeur (3) et de l'électrode avant (2).

La figure 1B est une vue de dessus de l'empilement précédent dans lequel ont été réalisées une transparence en bande et l'isolation des bus de collecte. Elle représente une succession de bandes horizontales opaques et transparentes. Les bandes horizontales opaques forment les zones photovoltaïques actives (5). Les bandes opaques verticales forment les bus de collecte (7+ et 7-) isolés électriquement des zones photovoltaïques actives (5).

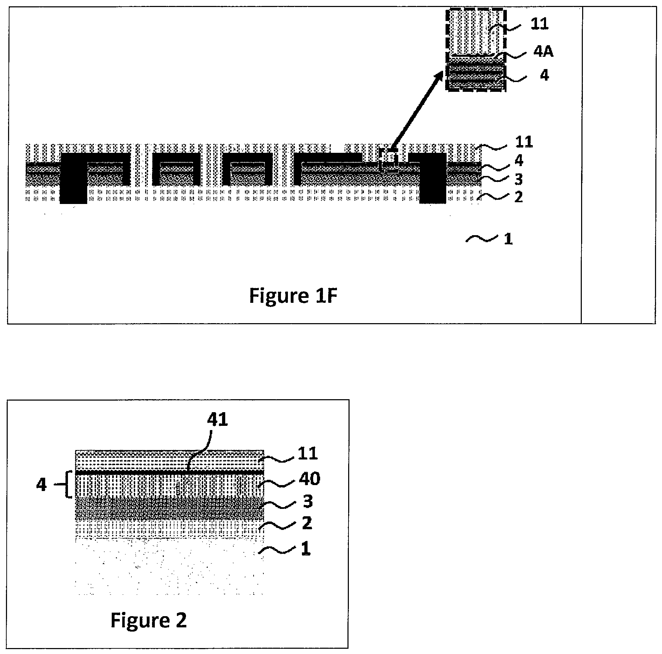

Les zones de transparence (6T) isolent électriquement les bandes photovoltaïques qui constituent les zones photovoltaïques actives (5) isolées formant des cellules unitaires entre elles. Afin de connecter électriquement ces zones photovoltaïques actives isolées entre elles (en série et/ou parallèle) et aux bus de collecte (7+ et 7-) pour obtenir un module photovoltaïque, il est nécessaire de réaliser des reprises de contact de type oxyde/métal. Dans la suite du document, le terme « via » est utilisé pour désigner la reprise de contact oxyde/métal décrite ci-dessous. La réalisation d'une reprise de contact de type via comprend plusieurs étapes consécutives. Considérons l'exemple d'une architecture en bandes semi-transparentes telle que celle de la figure 1B. On procède de la manière suivante.
**Etape 1** : Au sein des zones photovoltaïques actives (5), sont gravées des zones de reprises de contact (8). Ces zones de reprise de contact (8) sont dans l'exemple de la figure 1C, de forme carrée et parfaitement incluses au sein des zones photovoltaïques actives. Ces zones de reprise de contact (8) sont issues de la gravure de l'électrode arrière (4) et de la couche d'absorbeur (3) par des procédés de photolithographie conventionnelles connus de l'homme du métier. La figure 1D est une vue en coupe de la figure 1C selon la direction X où apparaissent les zones de reprise de contact (8) de type VIA.
**Etape 2 :** Une couche d'isolation électrique (9) est introduite pour isoler électriquement l'électrode avant (2) de l'électrode arrière (4). La figure 1E est une vue en coupe issue de la figure 1D à laquelle a été ajoutée la couche d'isolation (9). Cette couche d'isolation électrique est par exemple une résine transparente, permanente et photosensible. Des zones de reprise de contact (8) de type VIA sont laissées vacantes afin de réaliser la reprise de contact métal/oxyde ayant pour objet l'amélioration de la collecte des charges. L'architecture du module photovoltaïque nécessite des zones de reprise de contact (10) métal/métal. L'invention permet d'optimiser ce type de reprise de contact métal/métal.
**Etape 3** : Une couche métallique de reprise de contact (11) est alors déposée puis gravée par exemple grâce une nouvelle étape de photolithographie afin de connecter les deux bus (7+ et 7-) respectivement à l'électrode avant (2) et à l'électrode arrière (4) afin de rendre le module photovoltaïque semi-transparent fonctionnel tel que décrit à la figure 1F.

Cependant, dans les procédés connus de réalisation de la semi-transparence tels que décrit précédemment, l'électrode métallique, par exemple en aluminium, est laissée à l'air libre et un oxyde natif (4A), par exemple de l'oxyde d'aluminium appelé communément alumine, s'est formé à sa surface. Cet oxyde natif (4A) peut avoir une épaisseur de plusieurs nanomètres (3 à 6 nm dans le cas de l'alumine) et/ou avoir un pouvoir isolant important du fait de sa densité (3,4 dans le cas de l'alumine) et de sa permittivité électrique (10,5 dans le cas de l'alumine). La résistance électrique de contact qui en découle peut-être élevée et détériorer drastiquement les performances du module photovoltaïque.

L'invention vise à l'optimisation de la reprise de contact métal/métal constituée de l'électrode métallique (4) et du métal de reprise de contact (11). L'invention concerne une architecture spécifique de l'électrode métallique (4).

La figure 2 est une vue en coupe d'une zone de reprise de contact optimisée selon l'invention. L'électrode métallique (4) est constituée d'une couche conductrice métallique (40) et d'une couche barrière métallique (41).

La couche conductrice métallique (40) pourrait être de l'aluminium, du cuivre, de l'argent, de l'or, du platine, voir un alliage métallique. Cependant, pour maximiser les performances des dispositifs photovoltaïques semi-transparents, la couche conductrice métallique (40) doit être choisie en fonction de plusieurs critères :
- Compatibilité avec les autres matériaux de la cellule photovoltaïque, par exemple le cuivre ne peut être utilisé dans un tel dispositif si l'absorbeur est à base de silicium amorphe du fait de sa diffusion dans le matériau.
- Faible résistivité électrique pour minimiser la résistance électrique de contact.
- Faible coût.
- Possibilité de réaliser les dispositifs photovoltaïques semi-transparents selon des procédés industriels.
   Au vu de ces conditions, avantageusement, la couche conductrice métallique (40) sera soit
- en cuivre, dans un alliage de cuivre/aluminium pour les dispositifs photovoltaïques semi-transparents organiques et pérovskites, ou
- en aluminium pour les dispositifs photovoltaïques semi-transparents à base de silicium amorphe, organiques et pérovskites.

Il est à noter que les solutions retenues sont des couches métalliques oxydables dont l'oxyde natif détériore la reprise de contact entre l'électrode métallique et le métal de reprise de contact. L'épaisseur de la couche conductrice métallique sera comprise préférentiellement entre 50 nm et 2000 nm.

La couche barrière métallique (41) doit aussi être choisie en fonction de plusieurs critères, comme suit :
- L'oxydation de la couche barrière doit être faible voire inexistante,
- Le dépôt de la couche barrière métallique doit pouvoir être effectué sous vide immédiatement après le dépôt de la couche conductrice métallique (40),
- La nature du matériau doit être compatible avec les procédés industriels de semi-transparence des dispositifs photovoltaïques.

Préférentiellement le molybdène et le nickel sont utilisés comme couche barrière métallique (41) lorsque la couche conductrice métallique est en aluminium. L'épaisseur de la couche barrière (41) doit également être optimisée :
- Son épaisseur doit permettre d'assurer la fonction de barrière à l'oxydation de l'aluminium, elle doit être parfaitement homogène et avoir une épaisseur minimum de 5 nm. Il est à noter que les procédés industriels actuels ne permettant pas de réaliser une homogénéité suffisante, il est recommandé d'utiliser une couche barrière métallique de 20 nm d'épaisseur.
- Son épaisseur doit être compatible avec les procédés de gravure de la couche conductrice métallique. Si l'épaisseur est trop faible une sur-gravure de ladite couche barrière peut survenir et impacter les performances de la reprise de contact et donc du dispositif photovoltaïque.

Afin de répondre à l'ensemble de ces critères, l'épaisseur E1 de la couche barrière métallique (41) doit être supérieure à 5% de l'épaisseur E2 de la couche conductrice métallique (40).

L'avantage de la présente architecture est donc de permettre la réalisation de contacts électriques performants et de petites dimensions (quelques centaines de micromètres carrés) sur une couche conductrice métallique oxydable sans nécessiter l'utilisation d'une gravure plasma dans le cas où la mise en place de ce type de procédé de gravure s'avère contraignant pour des raisons de disponibilité d'équipement ou de coût.

### Références des figures :

| | |
|---|---|
| 1 | Substrat |
| 2 | Electrode avant |
| 3 | Absorbeur |
| 4 | Electrode arrière |
| 4A | Oxyde natif de l'électrode arrière |
| 40 | Couche conductrice métallique |
| 41 | Couche barrière métallique |
| 5 | Zones photovoltaïques actives |
| 6T | Zones de transparence |
| 6I | Zones de transparence d'isolation des bus de collecte |
| 7+, 7- | Bus de collecte |
| 8 | Zones de reprise de contact oxyde/métal |
| 9 | Couche d'isolation électrique |
| 10 | Zones de reprise de contact métal/métal |
| 11 | Couche métallique de reprise de contact |

### EXEMPLE DE REALISATION

Un exemple concret de dispositif photovoltaïque semi-transparent a été réalisé. Ses caractéristiques sont les suivantes :
- le substrat transparent est en verre, son épaisseur est de 550 µm,
- l'électrode avant (2) est constituée d'une couche d'oxyde de zinc d'une épaisseur de 1000 nm,
- l'absorbeur (3) est une couche photo active à base de silicium amorphe d'une épaisseur totale de 350 nm,
- l'électrode arrière (4) est composée d'un empilement:
   o d'une couche conductrice d'aluminium (40) d'une épaisseur de 500 nm, en contact avec ledit absorbeur (3),
   o une couche barrière (41) de molybdène d'une épaisseur de 50 nm, en contact avec ladite couche conductrice d'aluminium.
- une couche d'isolation électrique (9) en résine d'une épaisseur de 2000 nm,
- une couche d'aluminium de reprise de contact (11), d'une épaisseur de 500 nm.

La gravure de l'électrode arrière (4) est réalisée grâce à une solution d'acide phosphorique dont la concentration en acide phosphorique est de 70%. A température ambiante la différence de vitesse de gravure entre l'aluminium et le molybdène est inférieure à 20nm par minute, le molybdène étant le matériau qui se grave le plus vite. Ainsi, en réalisant une seule étape de masquage par photolithographie et une seule étape de gravure chimique, la sur gravure ou gravure latérale de la couche de molybdène par rapport à la couche d'aluminium est inférieure à 500nm ce qui est acceptable pour des motifs de plusieurs micromètres de large.

A titre d'exemple, la résistance électrique globale d'un dispositif photovoltaïque dont la zone active fait 10 cm² peut être divisée par deux en utilisant une électrode arrière protégée par une couche de molybdène telle que décrite dans cet exemple de réalisation.

## Revendications

1. Dispositif photovoitaïque semi-transparent à couches minces comportant au moins:
- un substrat transparent (1);
- une électrode avant (2) constituée d'un matériau électriquement conducteur et transparent, disposée sur le substrat transparent (1);
- une ou plusieurs couche(s) photo-active(s) appelées absorbeur (3);
- une électrode arrière (4) constituée d'un empilement d'au moins:
∘ une couche conductrice métallique (40) oxydable en contact avec ledit absorbeur(3);
∘ une couche barrière métallique (41) déposée de manière homogène sur l'ensemble de ladite couche conductrice métallique (40) et permettant de supprimer l'apparition d'un oxyde natif de ladite couche conductrice métallique (40);
- une couche métallique de reprise de contact (11);
- une zone de reprise de contact (10) de type électrode arrière/couche métallique de reprise de contact; l'épaisseur E1 de ladite couche barrière métallique (41) étant supérieure
à 5% de l'épaisseur E2 de ladite couche conductrice métallique (40) et étant supérieure à 5 nm.

2. Dispositif photovoltaïque semi-transparent à couches minces selon la revendication 1, **caractérisé en ce que** la couche barrière métallique (41) présente une épaisseur inférieure à 100 nm.

3. Dispositif photovoltaïque semi-transparent à couches minces selon l'une quelconque des revendications précédentes, **caractérisé en ce que** la couche barrière métallique (41) est une couche de molybdène, de nickel, d'argent, de palladium, de platine, d'or, de chrome ou de tungstène.

4. Dispositif photovoltaïque semi-transparent à couches minces selon l'une quelconque des revendications précédentes, **caractérisé en ce que** l'absorbeur (3) est une jonction à base de silicium amorphe.

5. Dispositif photovoltaïque semi-transparent à couches minces selon l'une quelconque des revendications précédentes, **caractérisé en ce que** la couche conductrice métallique (40) est une couche d'aluminium, de cuivre, d'argent ou un alliage Aluminium/Cuivre.

6. Dispositif photovoltaïque semi-transparent à couches minces selon l'une quelconque des revendications précédentes, **caractérisé en ce que** la couche conductrice métallique (40) a une épaisseur E2 comprise entre 50 nm et 2000 nm.

7. Dispositif photovoltaïque semi-transparent à couches minces selon l'une quelconque des revendications précédentes, **caractérisé en ce que** la zone (10) de reprise de contact métal/métal présente une surface de l'ordre de la centaine de micromètres carrés.

## Patentansprüche

1. Halbtransparente Dünnschicht-Photovoltaikvorrichtung, die mindestens Folgendes aufweist:
- ein transparentes Substrat (1);
- eine vordere Elektrode (2), die aus einem elektrisch leitenden und transparenten Material zusammengesetzt und auf dem transparenten Substrat (1) angeordnet ist;
- eine oder mehrere photoaktive Schichten, die als Absorber (3) bezeichnet werden;
- eine hintere Elektrode (4), die aus einem Stapel aufgebaut ist von mindestens:
∘ einer oxidierbaren metallischen leitenden Schicht (40), die mit dem Absorber (3) in Kontakt steht;
∘ eine metallische Barrierenschicht (41), die in homogener Weise auf der gesamten metallischen leitenden Schicht (40) aufgebracht ist und das sAuftreten eines nativen Oxids der metallischen leitenden Schicht (40) unterdrücken kann;
- eine metallische Kontaktschicht (11);
- einen Kontaktbereich (10) vom Typ hintere Elektrode/metallische Kontaktschicht;
wobei die Dicke E1 der metallischen Barrierenschicht (41) mehr als 5% der Dicke E2 der metallischen leitenden Schicht (40) beträgt und größer als 5 nm ist.

2. Halbtransparente Dünnschicht-Photovoltaikvorrichtung nach Anspruch 1, **dadurch gekennzeichnet, dass** die metallische Barrierenschicht (41) eine Dicke von weniger als 100 nm aufweist.

3. Halbtransparente Dünnschicht-Photovoltaikvorrichtung nach einem der vorhergehenden Ansprüche, **dadurch gekennzeichnet, dass** die metallische Barrierenschicht (41) eine Schicht aus Molybdän, Nickel, Silber, Palladium, Platin, Gold, Chrom oder Wolfram ist.

4. Halbtransparente Dünnschicht-Photovoltaikvorrichtung nach einem der vorhergehenden Ansprüche, **dadurch gekennzeichnet, dass** der Absorber (3) ein Übergang auf der Basis von amorphem Silizium ist.

5. Halbtransparente Dünnschicht-Photovoltaikvorrichtung nach einem der vorhergehenden Ansprüche, **dadurch gekennzeichnet, dass** die metallische leitende Schicht (40) eine Schicht aus Aluminium, Kupfer, Silber oder einer Aluminium/Kupfer-Legierung ist.

6. Halbtransparente Dünnschicht-Photovoltaikvorrichtung nach einem der vorhergehenden Ansprüche, **dadurch gekennzeichnet, dass** die metallische leitende Schicht (40) eine Dicke E2 zwischen 50 nm und 2000 nm aufweist.

7. Halbtransparente Dünnschicht-Photovoltaikvorrichtung nach einem der vorhergehenden Ansprüche, **dadurch gekennzeichnet, dass** der Metall/Metall-Kontaktbereich (10) eine Fläche in der Größenordnung von hundert Quadratmikrometern aufweist.

## Claims

1. A semi-transparent thin film photovoltaic device comprising at least:
- a transparent substrate (1);
- a front electrode (2) made of an electrically conductive and transparent material and disposed on the transparent substrate (1);
- one or more photoactive layers called absorber (3);
- a back electrode (4) made of a stack of at least:
∘ an oxidizable metallic conductive layer (40) in contact with said absorber (3);
∘ a metallic barrier layer (41) homogeneously deposited on the whole of said metallic conductive layer (40) and allowing to suppress the appearance of a native oxide of said metallic conductive layer (40);
- a metallic contact layer (11);
- a contact zone (10) of the type back electrode/metal contact layer;
wherein the thickness E1 of said metallic barrier layer (41) is greater than 5% of the thickness E2 of said metallic conductive layer (40) and is greater than 5 nm.

2. The semi-transparent thin film photovoltaic device of claim 1, **characterized in that** the metallic barrier layer (41) has a thickness of less than 100 nm.

3. The semi-transparent thin film photovoltaic device according to any of the preceding claims, **characterized in that** the metallic barrier layer (41) is a layer of molybdenum, nickel, silver, palladium, platinum, gold, chromium or tungsten.

4. The semi-transparent thin film photovoltaic device according to any of the preceding claims, **characterized in that** the absorber (3) is an amorphous silicon-based junction.

5. The semi-transparent thin film photovoltaic device according to any of the preceding claims, **characterized in that** the metallic conductive layer (40) is a layer of aluminium, copper, silver or an aluminium/copper alloy.

6. The semi-transparent thin film photovoltaic device according to any one of the preceding claims, **characterized in that** the metallic conductive layer (40) has a thickness E2 between 50 nm and 2000 nm.

7. The semi-transparent thin film photovoltaic device according to any one of the preceding claims, **characterized in that** the metal/metal contact zone (10) has a surface area of the order of a hundred square micrometres.
